(19) Europäisches Patentamt
European Patent Office
Office européen des brevets

(11) **EP 3 711 160 B1**

(12) **EUROPÄISCHE PATENTSCHRIFT**

(45) Veröffentlichungstag und Bekanntmachung des Hinweises auf die Patenterteilung:
**27.09.2023   Patentblatt 2023/39**

(21) Anmeldenummer: **18800592.0**

(22) Anmeldetag: **08.11.2018**

(51) Internationale Patentklassifikation (IPC):
*H03K 5/153* *(2006.01)*      *G01R 19/00* *(2006.01)*
*H03K 5/1536* *(2006.01)*     *G01R 19/165* *(2006.01)*
*G01R 19/175* *(2006.01)*

(52) Gemeinsame Patentklassifikation (CPC):
**H03K 5/153; G01R 19/0084;** G01R 19/16538;
G01R 19/175; H03K 5/1536

(86) Internationale Anmeldenummer:
**PCT/EP2018/080554**

(87) Internationale Veröffentlichungsnummer:
**WO 2019/096661 (23.05.2019 Gazette 2019/21)**

(54) **SCHALTUNGSANORDNUNG UND VERFAHREN ZUR ÜBERWACHUNG SINUSFÖRMIGER WECHSELSPANNUNGSSIGNALE**

CIRCUIT ASSEMBLY AND METHOD FOR MONITORING SINUSOIDAL ALTERNATING VOLTAGE SIGNALS

AGENCEMENT DE CIRCUIT ET PROCÉDÉ DE SURVEILLANCE DE SIGNAUX SINUSOÏDAUX DE TENSION ALTERNATIVE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.11.2017   DE 102017127070**

(43) Veröffentlichungstag der Anmeldung:
**23.09.2020   Patentblatt 2020/39**

(73) Patentinhaber: **Eaton Intelligent Power Limited Dublin 4 (IE)**

(72) Erfinder: **CULCA, Horea**
**53797 Lohmar (DE)**

(74) Vertreter: **Epping - Hermann - Fischer Patentanwaltsgesellschaft mbH Schloßschmidstraße 5 80639 München (DE)**

(56) Entgegenhaltungen:
**DE-A1- 19 748 632       JP-A- H03 189 569**
**US-A1- 2010 271 073       US-B1- 6 255 864**

**Beschreibung**

Die vorliegende Erfindung betrifft eine Schaltungsanordnung sowie ein Verfahren zur Überwachung eines sinusförmigen Wechselspannungssignals, insbesondere eines Eingangssignals elektronischer Steuergeräte, wie speicherprogrammierbare Steuerungen (SPS) oder Logikrelais, oder eines Eingangssignals bzw. -spannung von ähnlichen Geräten sowie ein entsprechendes Software-Produkt.

Die Produktnorm für SPS IEC/EN 61131, Teil 2 definiert u.a. die Eigenschaften von Eingangssignalen. Als Digitaleingänge werden Gleichspannungssignale (DC-Eingangssignale) und sinusförmige Wechselspannungssignale (AC-Eingangssignale) spezifiziert. Hier sind folgende Spannungen aufgeführt: 24V DC, 48V DC, 24V AC, 48V AC, 100/110/120V AC, 200/230/240VAC.

Bei kleinen, kompakten Geräten (wie z.B. Steuerrelais) ist es wünschenswert, verschiedene Versorgungen und Eingangssignale zu unterstützen, z.B. 24V AC und 24V DC. Damit kann man die Vielfalt der Gerätetypen reduzieren. Allerdings sollen auch die Kosten für Bauteile und Komponenten in solchen Geräten möglichst gering gehalten werden.

Eine Schwierigkeit bei der Überwachung von AC-Eingangssignalen besteht darin, dass in der Norm IEC/EN 61131 die Schwellenwerte (AC-Werte) für AC-Eingangssignale als Effektivwerte ($U_{rms}$) und nicht als Spitzen-(Peak-)werte definiert sind. Eine herkömmliche Vorgehensweise AC-Eingangssignale zu überwachen ist, die sinusförmigen Signale gleichzurichten und zu glätten, wodurch DC-Signale entstehen (abgesehen von der Restwelligkeit), diese mit einem definierten Schwellenwert zu vergleichen (vermittels eines Vergleichers) und einer CPU bzw. einem Mikrocontroller das Ergebnis als Digitalsignal (z.B. TTL-Pegel bzw. CMOS-Pegel, z.B. 5V oder 3,3V; CMOS ist die Abkürzung für komplementäre Metall-Oxid-Halbleiter, englisch complementary metal-oxidesemiconductor) zur Verfügung zu stellen. Die in dieser Art erzeugten Signale an einem Vergleicher-Eingang entsprechen allerdings dem Spitzen-(Peak-)wert ($U_{peak}$), nicht dem Effektivwert ($U_{rms}$) eines entsprechenden Eingangssignals.

Beispielsweise sind nach IEC/EN 61131-2 die normierten Schwellenwerte (DC-Werte) für 24V DC definiert als $U_{Lmax}$ = 5V (maximaler DC-Wert für ein Low-Signal) und $U_{Hmin}$ = 15V (minimaler DC-Wert für ein High-Signal) bei entsprechenden Eingangswerten von $U_{IN\,Lmax}$ = 5V (maximaler Eingangswert für ein Low-Signal) und $U_{IN\,Hmin}$ = 15V (minimaler Eingangswert für ein High-Signal). Beispielsweise sind nach IEC/EN 61131-2 die normierten Schwellenwerte (AC-Werte) für 24V AC definiert als $U_{Lmax,rms}$ = 5V (maximaler Effektiv-Wert für ein Low-Signal) und $U_{Hmin,rms}$ = 14V (minimaler Effektiv-Wert für ein High-Signal) bei entsprechenden gleichgerichteten und geglätteten Peak-Eingangswerten ( $U_{rms}$ x $\sqrt{2}$ ) von $U_{IN\,Lmax}$ = 7, 07V (maximaler Peak-Eingangswert für ein Low-Signal) und $U_{IN\,Hmin}$ = 19,8V (minimaler Peak-Eingangswert für ein High-Signal). Zur Überwachung der jeweiligen High-Signale und Low-Signale sowohl von AC-Eingangssignalen als auch von DC-Eingangssignalen muss daher ein Vergleicher mit einem definierten Schwellenwert etwa mittig zwischen 7,07V und 15V eingesetzt werden, also z.B. bei 11V.

Eine preiswerte Lösung für Vergleicher der oben genannten Art sind z.B. sogenannte CMOS HC-Gatter, wie z.B. ein sogenannter HC04-Inverter. Die CMOS HC-Eingangsschwellen liegen typischerweise bei $U_{DD}/2$ ($U_{DD}$ ist die Versorgungsspannung des Gatters) , sind aber nach "JEDEC" (Joint Electron Device Engineering Council) normiert und betragen $U_{IN,L\,max}$ = 30% $U_{DD}$ als maximalen Pegel für ein Low-Signal (z.B. 1,5V bei $U_{DD}$ = 5V) und $U_{IN,H\,min}$ = 70% $U_{DD}$ als minimalen Pegel für ein High-Signal (z.B. 3,5V bei $U_{DD}$ = 5V). Das bedeutet, dass ein Schwellenwert von $U_{DD}/2$ mit ±20% von $U_{DD}$ abweichen kann, also zwischen 0,6 x $U_{DD}/2$ und 1,4 x $U_{DD}/2$ liegen kann. Umgerechnet auf die 24V DC Schwellenwerte von 5V bzw. 15V (siehe oben) ergibt sich bei einem Mittelwert von $U_M$ = (5V + 15V)/2 = 10V als $U_{DD}/2$:

- $U_{IN,L}$ = 0,6 x 10V = 6V > 5V, 1V Reserve;
- $U_{IN,H}$ = 1,4 x 10V = 14V < 15V, 1V Reserve.

Somit kann ein CMOS HC-Gatter trotz der Toleranzen des Schwellenwertes als Vergleicher für 24V DC-Eingangssignale eingesetzt werden.

Bei einer Verwendung solcher CMOS HC-Gatter sowohl für eine Überwachung von 24V DC-Eingangssignalen als auch für eine Überwachung von 24V AC-Eingangssignalen verringert sich jedoch der mögliche Schwellenwertbereich von 5V bis 15V auf 7,07V bis 15V (siehe oben). Die gleiche Berechnung ergibt in diesem Fall bei einem Mittelwert von $U_M$ = (7,07V + 15V)/2 = 11,035V als $U_{DD}/2$:

- $U_{IN,L}$ = 0,6 x 11,035V = 6,621V < 7,07V, zu niedrig;
- $U_{IN,H}$ = 1,4 x 11,035V = 15,449 > 15V, zu hoch.

Das bedeutet, dass preiswerte CMOS HC-Gatter in diesem Fall nicht mehr zuverlässig eingesetzt werden können.

Aus EP 0935758 sind bereits eine Schaltungsanordnung und ein Verfahren zur Erfassung von AC-Eingangssignalen bekannt, wobei anders als bei der anfangs erwähnten herkömmlichen Lösung die AC-Eingangssignale nicht gefiltert werden, sondern lediglich in entsprechende Impulse umwandelt werden. Allerdings erfasst auch die aus EP 0935758 bekannte Methode durch Lesen von sinusförmigen AC-Eingangssignalen zu einem Zeitpunkt T/4 einer Periodendauer T nach einem Nulldurchgang die Spitzen-(Peak-)werte der Eingangssignale, wodurch die gleichen vorher dargestellten Probleme entstehen. Eine Schaltungsanordnung dieser Art wird auch im Dokument DE 197 48 632 A1 offenbart.

Es ist Aufgabe der Erfindung eine Schaltungsanordnung sowie ein Verfahren zur Überwachung eines sinusförmigen Wechselspannungssignals, insbesondere für Geräte der eingangs genannten Art, zu beschreiben, die einen flexibleren Einsatz von Vergleichern ermöglichen.

Die Aufgabe wird in einem ersten Aspekt durch eine Schaltungsanordnung zur Überwachung eines sinusförmigen Wechselspannungssignals gemäß Patentanspruch 1 gelöst. Weitergehende Ausgestaltungen sind in den Unteransprüchen offenbart.

Die Schaltungsanordnung weist einen Vergleicher auf, dem an einem Eingang ein zu überwachendes, sinusförmiges Wechselspannungssignal mit einer Periodendauer T oder ein daraus gewonnenes Signal zuführbar ist, wobei der Vergleicher eingerichtet ist an einem Ausgang ein erstes Ausgangssignal zu erzeugen, wenn das sinusförmige Wechselspannungssignal oder das daraus gewonnene Signal einen definierten Schwellenwert überschreitet. Das zu überwachende, sinusförmige Wechselspannungssignal kann entweder direkt in den Vergleicher gespeist werden oder zuvor vorverarbeitet werden, sodass ein daraus gewonnenes Signal dem Vergleicher zuführbar ist. Eine entsprechende Vorverarbeitung kann ein Gleichrichten durch einen Gleichrichter (z.B. zur Halbwellengleichrichtung) bzw. Tiefsetzen durch einen Tiefsetzer umfassen. Das zu überwachende, sinusförmige Wechselspannungssignal kann z.B. ein Spannungssignal einer Phase eines dreiphasigen Versorgungsnetzes sein.

Die Schaltungsanordnung weist ferner einen Nulldurchgangsdetektor auf, dem an einem Überwachungseingang das sinusförmige Wechselspannungssignal oder ein daraus gewonnenes Signal zuführbar ist, sodass an einem Ausgang des Nulldurchgangsdetektors ein zweites Ausgangssignal erzeugbar ist. Das sinusförmige Wechselspannungssignal kann entweder direkt in den Nulldurchgangsdetektor gespeist werden oder zuvor vorverarbeitet werden, sodass das daraus gewonnene Signal dem Nulldurchgangsdetektor zuführbar ist. Eine entsprechende Vorverarbeitung kann analog zu den oben genannten Maßnahmen ein Gleichrichten durch einen Gleichrichter (vorteilhaft Halbwellengleichrichtung) umfassen. Optional kann die Vorverarbeitung zusätzlich auch ein Strombegrenzen durch einen Widerstand oder ein Tiefsetzen durch einen Tiefsetzer umfassen.

Die Schaltungsanordnung weist ferner ein dem Nulldurchgangsdetektor nachgeschaltetes Zeitglied zur Erzeugung eines Taktsignals in Abhängigkeit vom zweiten Ausgangssignal auf.

Die Schaltungsanordnung weist ferner ein flankengesteuertes Flip-Flop auf. Der Ausgang des Vergleichers ist mit einem zustandsgesteuerten Eingang des Flip-Flops verbunden. Ein Ausgang des Zeitglieds ist mit einem flankengesteuerten Eingang des Flip-Flops verbunden. Auf diese Weise ist ein Zustandssignal an einem Ausgang des Flip-Flops erzeugbar. Ferner ist das Zeitglied eingerichtet, einen definierten Zustandswechsel des Taktsignals zu einem Zeitpunkt vorzugeben, der sich vom Zeitpunkt bei T/4 der Periodendauer T nach einem Nulldurchgang des sinusförmigen Wechselspannungssignals unterscheidet.

Das sinusförmige Wechselspannungssignal wird somit relativ zu dem definierten Schwellenwert überwacht. Der definierte Schwellenwert kann vorbestimmt und konstant sein.

Dadurch, dass der definierte Zustandswechsel des Taktsignals zu einem Zeitpunkt vorgeben ist, der sich von einem Zeitpunkt bei T/4 einer Periodendauer T nach einem Nulldurchgang des sinusförmigen Wechselspannungssignals unterscheidet, wird nicht der Spitzen-(Peak-)wert (Scheitelwert oder Amplitudenwert) des sinusförmigen Wechselspannungssignals für die Überwachung herangezogen, sondern ein Wert, der niedriger ist als der Spitzen-(Peak-)wert. Somit kann der Schwellenwert, der für die Überwachung des sinusförmigen Wechselspannungssignals herangezogen wird bzw. durch den Vergleicher vorgegeben oder definiert wird, niedriger sein als ein Schwellenwert, der für eine Auswertung des sinusförmigen Wechselspannungssignals hinsichtlich seines Spitzen-(Peak-)wertes notwendig wäre. Durch "Verschieben" bzw. Verlagern des Auswertezeitpunktes des sinusförmigen Wechselspannungssignals hinsichtlich des Schwellenwertes weg von einem Zeitpunkt des Auftretens des Spitzen-(Peak-)wertes kann der Schwellenwert insbesondere niedriger gewählt sein als der Spitzen-(Peak-)wert, wobei dennoch eine Auswertung möglich ist, ob das sinusförmige Wechselspannungssignal eine definierte Schwelle überschreitet oder nicht.

Auf diese Weise kann ein Vergleicher der oben erläuterten Art hinsichtlich des herangezogenen Schwellenwertes flexibler eingesetzt werden. Insbesondere können auf diese Weise auch toleranzbehaftete Vergleicher eingesetzt werden, die aufgrund ihrer Toleranzen einen Schwellenwert vorgeben, der niedriger ist als der Spitzen-(Peak-)wert des sinusförmigen Wechselspannungssignals. Allgemein können Vergleicher flexibel in Anwendungsfällen eingesetzt werden, die einen bestimmten Schwellenwert vorgeben bzw. erfordern, wobei der Schwellenwert niedriger ist als ein Spitzen-(Peak-)wert des zu überwachenden sinusförmigen Wechselspannungssignals, und dennoch eine zuverlässige und fehlerfreie Auswertung des sinusförmigen Wechselspannungssignals erforderlich ist.

Erfindungsgemäß ist das Zeitglied eingerichtet, einen definierten Zustandswechsel des Taktsignals zu einem Zeitpunkt bei T/8 bzw. 3T/8 der Periodendauer T nach einem Nulldurchgang des sinusförmigen Wechselspannungssignals vorzugeben. Dadurch, dass der definierte Zustandswechsel des Taktsignals in diesen Ausgestaltungen zu einem Zeitpunkt bei T/8 bzw. 3T/8 einer Periodendauer T nach einem Nulldurchgang des sinusförmigen Wechselspannungssignals vorgegeben ist, korreliert der Zeitpunkt des Zustandswechsels des Taktsignals mit dem Zeitpunkt des Auftretens eines Effektivwertes ($U_{rms}$) des sinusförmigen Wechselspannungssignals bzw. des daraus gewonnen Signals. Der Effektivwert ($U_{rms}$) ist bekanntlich niedriger als der Spitzen-(Peak-)wert ($U_{peak}$) des zu überwachenden AC-Signals.

Allgemein gilt $U_{rms} = 1/\sqrt{2}\, U_{peak}$ bzw. $\sin(45°) = 1/\sqrt{2}$. Damit entspricht die Amplitude des sinusförmigen Wechselspannungssignals zum Zeitpunkt T/8 (45°) genau dem Effektivwert ($U_{rms}$). Entsprechendes gilt auch für den Zeitpunkt 3T/8. Bei Auftreten des definierten Zustandswechsels des Taktsignals wird der flankengesteuerte Eingang des Flip-Flops getriggert und dabei der Ausgang des Vergleichers am zustandsgesteuerten Eingang des Flip-Flops gelesen/übernommen. Am Ausgang des Vergleichers wird das erste Ausgangssignal erzeugt, wenn das sinusförmige Wechselspannungssignal oder das daraus gewonnene Signal den definierten Schwellenwert überschreitet. Auf diese Weise kann der Effektivwert des sinusförmigen Wechselspannungssignals bzw. des daraus erzeugten Signals relativ zu dem definierten Schwellenwert überwacht werden.

Die Schaltungsanordnung ermöglicht in dieser Ausgestaltung insbesondere, einen Schwellenwert für die Überwachung eines normierten AC-Eingangssignals heranzuziehen bzw. auszuwählen oder zu dimensionieren, der in einem Schwellenwertbereich zwischen dem maximalen Effektiv-Schwellenwert für ein Low-Signal und dem minimalen Effektiv-Schwellenwert für ein High-Signal des sinusförmigen Wechselspannungssignals liegt (siehe z.B. die eingangs erläuterten Signalschwellen). Das hat den Vorteil, dass ein Schwellenwert verwendet werden kann, der innerhalb zulässiger Grenzen eines toleranzbehafteten Vergleichers liegt, der für eine Überwachung eines Gleichspannungssignals ausgelegt ist, selbst wenn dieser Schwellenwert aufgrund der Toleranz des Vergleichers niedriger ist als ein maximaler Spitzen-(Peak-)wert ($U_{peak}$) des Low-Signals des sinusförmigen Wechselspannungssignals.

Die Schaltungsanordnung kann derart eingerichtet sein, dass dem Vergleicher an seinem Eingang alternativ zum sinusförmigen Wechselspannungssignal ein zu überwachendes Gleichspannungssignal oder ein daraus gewonnenes Signal zuführbar ist, wobei der Vergleicher eingerichtet ist an seinem Ausgang das erste Ausgangssignal zu erzeugen, wenn das Gleichspannungssignal oder das daraus gewonnene Signal den definierten Schwellenwert überschreitet. Somit ermöglicht die Schaltungsanordnung sowohl eine Überwachung von sinusförmigen Wechselspannungssignalen (AC-Eingangssignalen) als auch eine Überwachung von Gleichspannungssignalen (DC-Eingangssignalen). Hierfür wird lediglich ein Vergleicher benötigt, wobei lediglich ein einziger Schwellenwert definiert werden muss. Dadurch wird ermöglicht, dass eine kombinierte Überwachung sowohl von sinusförmigen Wechselspannungssignalen als auch von Gleichspannungssignalen an eingangs erläuterten Geräten mit einfach und flexibel einzustellenden Vergleichern durchgeführt werden kann. Insbesondere können preiswerte Vergleicher, z.B. CMOS HC-Gatter, flexibel eingesetzt werden. Die Schaltungsanordnung ist dennoch einfach zu implementieren.

Z.B. kann ein theoretischer Schwellenwert von 9,5V als Mittelwert zwischen dem maximalen Effektiv-Schwellenwert für ein Low-Signal (5V) und dem minimalen Effektiv-Schwellenwert für ein High-Signal (14V) des sinusförmigen Wechselspannungssignals definiert werden. Eine eingangs erläuterte Toleranz eines eingesetzten CMOS HC-Gatters beträgt dann gemäß obiger Berechnung:

- $U_{IN,L}$ = 0,6 x 9,5V = 5,7V > 5V;
- $U_{IN,H}$ = 1,4 x 9,5V = 13,3V < 14V. Somit können trotz einer Toleranz bzw. Variabilität des tatsächlichen Schwellenwertes des eingesetzten Vergleichers zwischen 5,7V und 13,3V sowohl die normierten DC-Werte von DC-Signalen (maximal 5V für Low-Signale bzw. minimal 15V für High-Signale) als auch die normierten Effektiv-Schwellenwerte von AC-Signalen (5V für Low-Signale bzw. 14V für High-Signale) fehlerfrei überwacht werden. Andere Dimensionierungen bzw. Auswertezeitpunkte sind natürlich anwendungsspezifisch denkbar.

In diversen Ausführungsformen der Schaltungsanordnung ist der Vergleicher ein Komparator, wobei der Eingang ein erster Vergleichseingang des Komparators ist zum Vergleich des zu überwachenden, sinusförmigen Wechselspannungssignals oder des daraus gewonnenen Signals mit dem an einem zweiten Vergleichseingang des Komparators anliegenden, definierten Schwellenwert. Ein Komparator hat gegenüber einem einfacheren Vergleicher, z.B. einem CMOS HC-Vergleicher, den Vorteil, dass ein genauerer Schwellenwert vorgegeben werden kann, ohne dass dieser erheblichen Toleranzen ausgesetzt ist.

In diversen Ausführungsformen der Schaltungsanordnung, insbesondere vorteilhaft unter Einsatz eines Komparators als Vergleicher, sind dem Vergleicher an seinem Eingang alternativ verschiedene zu überwachende Gleichspannungssignale oder jeweils daraus gewonnene Signale zuführbar, wobei der Vergleicher eingerichtet ist an seinem Ausgang das erste Ausgangssignal zu erzeugen, wenn ein entsprechendes anliegendes Gleichspannungssignal oder das daraus gewonnene Signal den definierten Schwellenwert überschreitet. Der Schwellenwert kann dabei derart festgelegt sein, dass er unterhalb eines Spitzen-(Peak-)wertes des sinusförmigen Wechselspannungssignals und oberhalb eines DC-Wertes eines jeweiligen Gleichspannungssignals liegt. Somit können neben dem sinusförmigen Wechselspannungssignal alternativ mehrere verschiedene Gleichspannungssignale unter Verwendung eines einzigen definierten Schwellenwertes überwacht werden, selbst wenn ein oder mehrere der Gleichspannungssignale einen Schwellenwert erfordern, der unterhalb des Spitzen-(Peak-)wertes des sinusförmigen Wechselspannungssignals liegt. Beispielsweise ist eine kombinierte Überwachung von 24V AC, 24V DC und 12V DC möglich, wobei der Schwellenwert z.B. bei 6V festgelegt ist. Der Schwellenwert liegt somit unterhalb des maximalen Spitzen-(Peak-)wertes für ein Low-Signal (normiert auf 7,07V) des sinusförmigen Wechselspannungssignals (und natürlich auch unterhalb des minimalen Spitzen-(Peak-)wertes von normiert 19,8V für ein High-Signal des sinusförmigen Wechselspannungssignals) und oberhalb eines maximalen DC-Wertes für ein Low-Signal (normiert auf 5V) des jeweiligen Gleichspannungssignals (und natürlich unterhalb des minimalen DC-Wertes von normiert 15V für ein High-Signal des Gleichspannungssignals). Ein Schwellenwert von ca. 6V (z.B. 6,4V) hat sich auch für die Überwachung einer maximalen unteren DC-Schwelle (Low-Signal) bzw. einer minimalen oberen DC-Schwelle (High-Signal) eines überwachten, in der Norm IEC/EN 61131-2 nicht definierten, 12V DC-Signals unter Betrachtung der Berechnungsformel von Anhang B der Norm IEC/EN 61131-2 als ausreichend herausgestellt.

In diversen Ausführungsformen der Schaltungsanordnung ist das Zeitglied eingerichtet, durch das zweite Ausgangssignal zur Erzeugung des Taktsignals getriggert zu werden. Somit löst das zweite Ausgangssignal das Taktsignal aus.

In diversen Ausführungsformen der Schaltungsanordnung sind das Flip-Flop und/oder das Zeitglied durch Software innerhalb eines Mikrocontrollers realisiert. Auf diese Weise ist eine sehr einfache Implementierung der Schaltungsanordnung bzw. von Teilen der Schaltungsanordnung in Software möglich.

In diversen Ausführungsformen weist die Schaltungsanordnung einen Umschalter zum Umschalten eines Signalausgangs der Schaltungsanordnung zwischen dem Ausgang des Flip-Flops und dem Ausgang des Vergleichers auf, wobei der Umschalter vermittels eines Steuersignals steuerbar ist. Dieses Steuersignal kann z.B. das Taktsignal des Zeitglieds sein. Alternativ kann das Steuersignal das zweite Ausgangssignal oder ein daraus gewonnenes Signal sein. Vermittels des Umschalters kann zwischen einer Überwachung eines (oder mehrerer) Gleichspannungssignals und einer Überwachung eines sinusförmigen Wechselspannungssignals umgeschaltet werden. Bei einer Überwachung eines Gleichspannungssignals wird der Signalausgang der Schaltungsanordnung unmittelbar (direkt) auf den Ausgang des Vergleichers geschaltet, sodass am Ausgang der Schaltungsanordnung das erste Ausgangssignal ausgegeben werden kann, wenn das Gleichspannungssignal oder das daraus gewonnene Signal den definierten Schwellenwert überschreitet. Bei einer Überwachung des sinusförmigen Wechselspannungssignals wird der Signalausgang der Schaltungsanordnung dagegen auf den Ausgang des Flip-Flops geschaltet, sodass am Ausgang der Schaltungsanordnung das Zustandssignal des Flip-Flops ausgegeben werden kann, das über das Taktsignal des Zeitglieds bei T/8 bzw. 3T/8 einer Periodendauer T nach einem Nulldurchgang des sinusförmigen Wechselspannungssignals getriggert wird. Der Umschalter ist über das Taktsignal des Zeitglieds z.B. derart steuerbar, dass ein Umschalten von einer DC-Überwachung (Gleichspannungssignal) auf eine AC-Überwachung (sinusförmiges Wechselspannungssignal) erfolgt, wenn das Taktsignal vorliegt, welches seinerseits durch eine Detektion von Nulldurchgängen des sinusförmigen Wechselspannungssignals über den Nulldurchgangsdetektor getriggert wird.

Die obige Aufgabe wird in einem zweiten Aspekt durch ein Verfahren zur Überwachung eines sinusförmigen Wechselspannungssignals gemäß Patentanspruch 5 gelöst. Weitergehende Implementierungen sind in den Unteransprüchen offenbart.

Das Verfahren umfasst die folgenden Verfahrensschritte:

- Erfassen eines zu überwachenden, sinusförmigen Wechselspannungssignals mit einer Periodendauer T,
- Prüfen, ob das erfasste sinusförmige Wechselspannungssignal oder ein daraus gewonnenes Signal einen definierten Schwellenwert überschreitet, und in Abhängigkeit davon Erzeugen eines ersten Ausgangssignals,
- Überwachen der Nulldurchgänge des sinusförmigen Wechselspannungssignals oder eines daraus gewonnenen Signals und in Abhängigkeit davon Erzeugen eines zweiten Ausgangssignals,

- Erzeugen eines Taktsignals in Abhängigkeit vom zweiten Ausgangssignal und
- Erzeugen eines Zustandssignals durch Auswerten des ersten Ausgangssignals im Zeitpunkt eines definierten Zustandswechsels des Taktsignals,

wobei der definierte Zustandswechsel des Taktsignals zu einem Zeitpunkt vorgegeben wird, der sich vom Zeitpunkt bei T/4 der Periodendauer T nach einem Nulldurchgang des sinusförmigen Wechselspannungssignals unterscheidet. Auch ein derartiges Verfahren erzielt somit auf einfache Weise die Vorteile, wie sie im Zusammenhang mit einer Schaltungsanordnung der oben erläuterten Art dargestellt sind.

Erfindungsgemäß wird der definierte Zustandswechsel des Taktsignals zu einem Zeitpunkt bei T/8 bzw. 3T/8 der Periodendauer T nach einem Nulldurchgang des sinusförmigen Wechselspannungssignals vorgegeben. Auch an dieser Stelle gelten die oben im Zusammenhang mit einer Schaltungsanordnung erläuterten Vorteile analog.

In diversen Implementierungen des Verfahrens wird das Taktsignal durch ein Zeitglied erzeugt, das durch das zweite Ausgangssignal zur Erzeugung des Taktsignals getriggert wird. Auf diese Weise wird das Taktsignal in Abhängigkeit vom zweiten Ausgangssignal ausgelöst, das seinerseits aus einer Nulldurchgangs-Detektion des sinusförmigen Wechselspannungssignals gewonnen wird.

In diversen Implementierungen des Verfahrens ist das Zeitglied softwaregesteuert bzw. softwareimplementiert innerhalb eines Mikrocontrollers realisiert. In diesen Implementierungen können die folgenden Verfahrensschritte durchgeführt werden:

- Erzeugen eines ersten Interrupts im Mikrocontroller durch das zweite Ausgangssignal,
- Starten eines Timers des Mikrocontrollers bei Auftreten des ersten Interrupts zur Realisierung des Zeitglieds,
- Erzeugen eines zweiten Interrupts im Mikrocontroller bei Ablauf des Timers,
- Lesen (und optional Speichern) des bei Auftreten des zweiten Interrupts vorliegenden Wertes des ersten Ausgangssignals als Zustandssignal. Derartige Maßnahmen ermöglichen eine besonders einfache und schnelle Verarbeitung des erfassten sinusförmigen Wechselspannungssignals in das entsprechende Zustandssignal für eine weitere (logische) Verarbeitung innerhalb eines elektronischen Gerätes, in dem das Verfahren implementiert wird.

In diversen Implementierungen des Verfahrens werden die folgenden weiteren Verfahrensschritte durchgeführt:

- Erfassen eines (oder mehrerer verschiedener) zu überwachenden Gleichspannungssignals alternativ zum sinusförmigen Wechselspannungssignal,
- Prüfen, ob das erfasste Gleichspannungssignal oder ein daraus gewonnenes Signal den definierten Schwellenwert überschreitet, und in Abhängigkeit davon Erzeugen des ersten Ausgangssignals.

Der Schwellenwert wird oberhalb oder unterhalb eines Spitzen-(Peak-)wertes des sinusförmigen Wechselspannungssignals und oberhalb eines maximalen DC-Wertes des Gleichspannungssignals festgelegt. Wird der Schwellenwert unterhalb eines Spitzen-(Peak-)wertes des sinusförmigen Wechselspannungssignals und oberhalb eines DC-Wertes des Gleichspannungssignals festgelegt, können durch das Verfahren neben dem sinusförmigen Wechselspannungssignal alternativ ein oder mehrere verschiedene Gleichspannungssignale unter Verwendung eines einzigen definierten Schwellenwertes überwacht werden, selbst wenn eines oder mehrere der Gleichspannungssignale einen Schwellenwert erfordern, der unterhalb des Spitzen-(Peak-)wertes des sinusförmigen Wechselspannungssignals liegt. Beispielsweise ist eine kombinierte Überwachung von 24V AC, 24V DC und 12V DC möglich, wobei der Schwellenwert z.B. bei ca. 6V, z.B. bei 6,4V festgelegt ist. Der Schwellenwert liegt somit unterhalb des maximalen Spitzen-(Peak-)wertes für ein Low-Signal (normiert auf 7,07V) des sinusförmigen Wechselspannungssignals (und natürlich auch unterhalb des minimalen Spitzen-(Peak-)wertes von normiert 19,8V für ein High-Signal des sinusförmigen Wechselspannungssignals) und oberhalb eines maximalen DC-Wertes für ein Low-Signal (normiert auf 5V) des jeweiligen Gleichspannungssignals (und auch unterhalb des minimalen DC-Wertes von normiert 15V für ein High-Signal des jeweiligen Gleichspannungssignals). Ein Schwellwert von 6V hat sich auch für die Überwachung einer unteren Schwelle (Low-Signal) eines überwachten 12V DC-Signals als ausreichend herausgestellt. Auch hier ergeben sich die im Zusammenhang mit einer entsprechenden Schaltungsanordnung der oben erläuterten Art dargestellten Vorteile analog.

Das Verfahren kann teilweise oder vollständig in Software implementiert sein, die eingerichtet ist innerhalb eines Mikrocontrollers ausgeführt zu werden und die bei ihrer Ausführung ein entsprechendes Verfahren durchführt. Der Mikrocontroller kann das erste und das zweite Ausgangssignal in Echtzeit erfassen. Die Software kann in Echtzeit ausgeführt werden.

Sämtliche Aspekte, Maßnahmen und Merkmale einer oben erläuterten Schaltungsanordnung können in Aspekten, Maßnahmen und Merkmalen eines oben erläuterten Verfahrens ihren Niederschlag finden und umgekehrt.

Vorteilhaft finden die Schaltungsanordnung bzw. das Verfahren der oben erläuterten Art Anwendung in einem elektronischen Gerät, insbesondere in speicherprogrammierbaren Steuerungen, Logikrelais oder ähnlichen Geräten.

Weitere vorteilhafte Aspekte sind in den zugehörigen Unteransprüchen offenbart.

Die Erfindung wird nachfolgend anhand mehrerer Figuren näher beschrieben.

Es zeigen:

Figuren 1A und 1B:    Ausführungsformen einer Schaltungsanordnung,

Figur 2:                  eine beispielhafte Verarbeitung eines sinusförmigen Wechselspannungssignals und

Figur 3: ein schematisiertes Ablaufdiagramm einer softwaregesteuerten Verarbeitung.

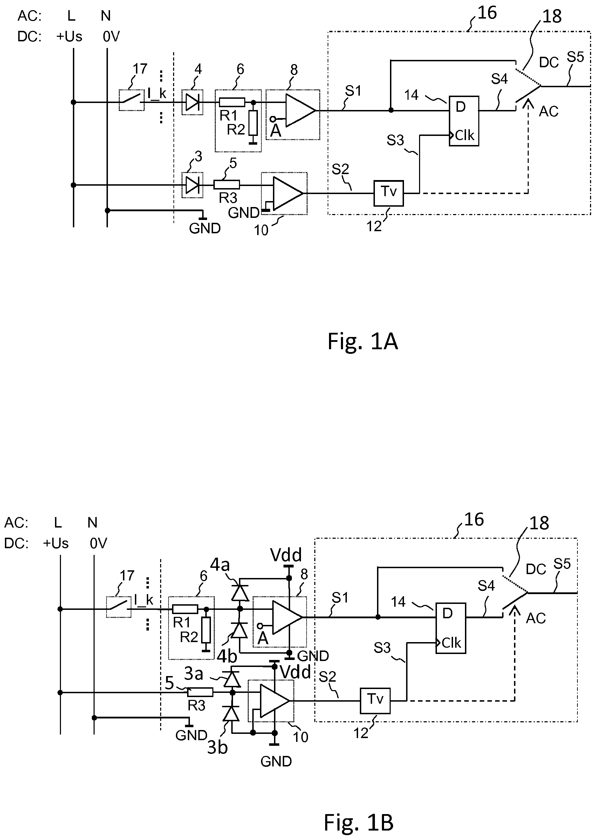

In Fig. 1A wird prinzipiell eine Schaltungsanordnung dargestellt, die eine Verarbeitung eines AC-Eingangssignals (sinusförmiges Wechselspannungssignal) oder alternativ eines DC-Eingangssignals (Gleichspannungssignal) ermöglicht. Das AC-Eingangssignal stammt in diesem Ausführungsbeispiel aus einer Phase L eines Versorgungsnetzes. Das DC-Eingangssignal stammt aus einer DC-Quelle +Us. Mit N bzw. 0V ist der Neutralleiter (für AC) bzw. das Bezugspotential (für DC) bezeichnet. Die Schaltungsanordnung findet z.B. Anwendung in einer speicherprogrammierbaren Steuerung oder einem Logikrelais, o.ä. Es wird ein zweites Ausgangssignal bzw. Nulldurchgangssignal S2 aus der Phase L des Gerätes durch einen Nulldurchgangsdetektor 10 erzeugt. Der Nulldurchgangsdetektor 10 ist in Fig. 1A in Form eines Komparators aufgebaut, der die Versorgungsspannung mit einem Massepotential GND (Null-Referenz) oder einem annähernden Massepotential vergleicht. Auf diese Weise kann die Art des an der Phase L anliegen Spannungssignals detektiert werden. Liegt ein AC-Eingangssignal an, detektiert der Nulldurchgangsdetektor 10 Nulldurchgänge und erkennt so das anliegende AC-Eingangssignal. In diesem Fall erzeugt der Nulldurchgangsdetektor 10 das zweite Ausgangssignal bzw. Nulldurchgangssignal S2. Das zweite Ausgangssignal bzw. Nulldurchgangssignal S2 triggert dann wiederum das Zeitglied Tv 12, das das Taktsignal S3 erzeugt. Liegt dagegen ein DC-Eingangssignal an, detektiert der Nulldurchgangsdetektor 10 keine Nulldurchgänge. In diesem Fall erzeugt der Nulldurchgangsdetektor 10 das zweites Ausgangssignal bzw. Nulldurchgangssignal S2 nicht. Auch das Zeitglied Tv 12 wird in diesem Fall nicht getriggert und erzeugt auch das Taktsignal S3 nicht.

Die Versorgungsspannung (Eingangssignal) an der Phase L wird zunächst gleichgerichtet, bevor sie in den Nulldurchgangsdetektor 10 eingespeist wird. Dies ist in Fig. 1A schematisiert in Form einer Diode 3 veranschaulicht. Zwischen der Diode 3 und dem Nulldurchgangsdetektor 10 kann ein Widerstand R3, 5 angeordnet sein. Die Diode 3 führt beispielsweise eine Halbwellengleichrichtung durch, sodass aus dem daraus gewonnenen Signal durch den Nulldurchgangsdetektor 10 gemäß den obigen Erläuterungen das Nulldurchgangssignal S2 erzeugt werden kann. Der Nulldurchgangsdetektor 10 ist als Komparator implementiert.

In Fig. 1A wird das Eingangssignal - repräsentativ ist ein Eingangssignal I_k dargestellt - gleichgerichtet (durch einen Gleichrichter 4), heruntergeteilt (durch einen Tiefsetzer 6, hier in Form eines einfachen Spannungsteilers mit zwei Widerständen R1, R2) und mit einem vordefinierten Schwellenwert A verglichen (durch einen Komparator 8) und somit als erstes Ausgangssignal S1 "digitalisiert". Das Eingangssignal I_k ist ein Spannungssignal. Der Gleichrichter weist eine Diode 4 auf, die diskret realisiert sein kann. Eine in Fig. 1A nicht gezeigte Referenzspannungsquelle gibt den Schwellenwert A vor. Der Schwellenwert A kann z.B. konstant sein.

In dem Falle, dass vermittels des Nulldurchgangsdetektors 10 keine Nulldurchgänge des Eingangssignals I_k detektiert werden, wird auch das Signal S2 und somit das Taktsignal S3 nicht erzeugt (siehe obige Erläuterungen). In diesem Fall bleibt ein Umschalter 18 in einer in Fig. 1A dargestellten oberen Position (DC-Betrieb). In dieser Stellung des Umschalters 18 wird der Ausgang des Komparators 8 (an dem das Signal S1 erzeugt wird) unmittelbar auf dem Ausgang S5 der Schaltungsanordnung gelegt. Somit liegt das erste Ausgangssignal S1 am Ausgang S5 an. So kann bei Vorliegen eines DC-Eingangssignals dieses vermittels des Komparators 8 überwacht werden. Überschreitet das DC-Eingangssignal den vorgegebenen Schwellenwert A, so erzeugt der Komparator 8 das Signal S1 und gibt dieses vermittels des Umschalters 18 unmittelbar am Ausgang S5 aus.

In dem alternativen Fall, dass vermittels des Nulldurchgangsdetektors 10 Nulldurchgänge des Eingangssignals I_k detektiert werden, wird auch das Signal S2 und somit das Taktsignal S3 erzeugt (siehe obige Erläuterungen). In diesem Fall schaltet der Umschalter 18 - getriggert durch das Zeitglied Tv 12 (z.B. über das Taktsignal S3 oder ein anderes Steuersignal, siehe gestrichelte Linie in Fig. 1A) - auf die in Fig. 1A dargestellte untere Position (AC-Betrieb) um. In dieser Stellung des Umschalters 18 wird der Ausgang des Komparators 8, d.h. das erste Ausgangssignal S1 an den Dateneingang D des Flip-Flops 14 eingespeist. Der Takteingang Clk wird von dem erzeugten Taktsignal S3 gesteuert. Die Komponenten 12, 14 und 18 sind im Ausführungsbeispiel gemäß Fig. 1A in einem Mikrocontroller 16 implementiert. Das erste Ausgangssignal S1 wird als normaler Eingang des Mikrocontrollers 16 zugeschaltet. Das Nulldurchgangssignal S2 wird an einem Interrupt-Eingang des Mikrocontrollers 16 zugeschaltet.

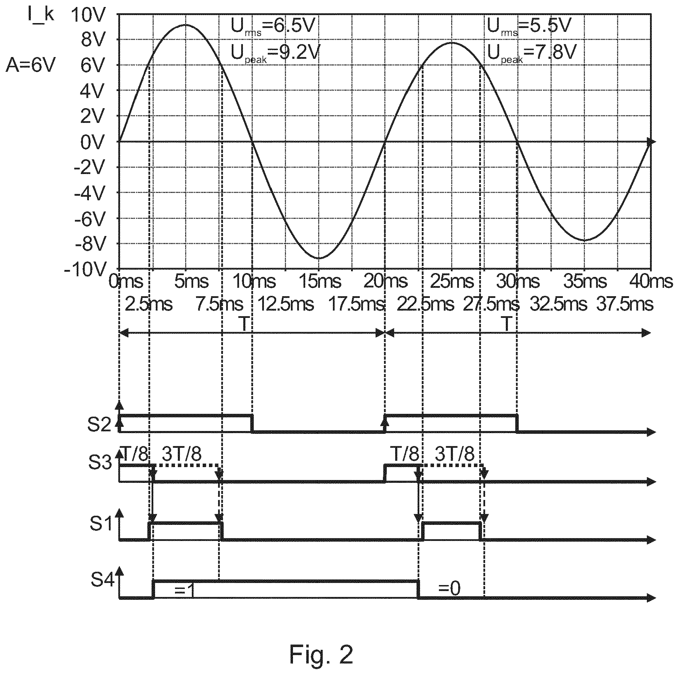

Die Generierung und Funktion des Taktsignals S3 wird nachfolgend im Detail erläutert (vergleiche Fig. 1A mit Fig. 2). Hierbei wird davon ausgegangen, dass ein AC-Eingangssignal I_k anliegt und der Umschalter 18 im AC-Betrieb gestellt ist.

Ausgehend vom Nulldurchgangssignal S2 erzeugt das Zeitglied Tv, 12 das Taktsignal S3 als Takt für das Flip-Flop 14. Das Taktsignal S3 weist einen definierten Zustandswechsel (fallende Taktflanke, siehe Fig. 2) auf, der nach einer Verzögerung von T/8 bzw. 3T/8 einer Periodendauer T nach einem Nulldurchgang des AC-Eingangssignals I_k (detektiert durch das Nulldurchgangssignal S2) auftritt. An diesem Zeitpunkt liegt der Effektivwert des sinusförmigen AC-Eingangssignals I_k vor. Dies kann mathematisch gezeigt werden durch folgende Berechnung. Das sinusförmige AC-Eingangssignals I_k entspricht

$$u(t) = U_{peak} \sin(\omega t)$$

mit dem Spitzen-(Peak-) wert $U_{peak}$. Löst man diese mathematische Signalbeschreibung folgendermaßen auf:

$$\omega t = \arcsin\left(\frac{u(t)}{\sqrt{2}U_{rms}}\right)$$

wobei $U_{peak} = \sqrt{2}U_{rms}$ und $U_{rms}$ dem Effektivwert entspricht, so erhält man für den gewünschten Zeitpunkt $t_x$, an dem der Effektivwert $U_{rms}$ vorliegt, folgende Beziehung:

$$\omega t_X = \arcsin\left(\frac{u(t_X)}{\sqrt{2}U_{rms}}\right) = \arcsin\left(\frac{U_{rms}}{\sqrt{2}U_{rms}}\right) = \arcsin\left(\frac{1}{\sqrt{2}}\right) = \frac{\pi}{4} \quad \text{bzw.}$$

$$t_X = \frac{1}{\omega}\frac{\pi}{4} = \frac{T}{2\pi}\frac{\pi}{4} = \frac{T}{8} \ .$$

$$\sin(\omega t) = \sin\left(\omega t + \frac{\pi}{2}\right)$$

Nachdem gilt: erhält man für den zweiten möglichen Zeitpunkt $t_x$:

$$\omega t_X = \frac{\pi}{4} + \frac{\pi}{2} = \frac{3\pi}{4} \quad \text{bzw.} \quad t_X = \frac{1}{\omega}\frac{3\pi}{4} = \frac{T}{2\pi}\frac{3\pi}{4} = \frac{3T}{8} \ .$$

Somit ist gezeigt, dass zu den Zeitpunkten T/8 bzw. 3T/8 einer Periodendauer T nach einem Nulldurchgang des AC-Eingangssignals I_k jeweils der Effektivwert des AC-Eingangssignals I_k vorliegt.

Das Taktsignal S3 triggert das Flip-Flop 14 an dessen flankengesteuertem Eingang Clk, wobei zum jeweiligen Zeitpunkt eines entsprechenden Zustandswechsels (fallende Taktflanke) des Taktsignals S3 (bei T/8 bzw. 3T/8) der Wert des ersten Ausgangssignal S1 am Dateneingang D des Flip-Flops 14 übernommen wird und somit das Zustandssignal S4 am Ausgang des Flip-Flops 14 erzeugt wird. Alternativ kann bei geeigneter Auslegung des Taktsignals S3 und des Flip-Flops 14 anstelle einer fallenden Taktflanke auch eine steigende Taktflanke verwendet werden. Schließlich wird das Zustandssignal S4 am Ausgang S5 (siehe Fig. 1A) bereitgestellt und kann weiter verarbeitet werden, z.B. durch eine Logikschaltung des elektronischen Gerätes (nicht dargestellt), in dem die Schaltungsanordnung Anwendung findet.

Ist das Eingangssignal I_k gleich Null (Schalter 17 geöffnet), so ist das erste Ausgangssignal S1 des Komparators 8 immer "0" und im Flip-Flop 14 wird zu jedem Zeitpunkt der Wert "0" gespeichert. Liegt ein gültiges Eingangssignal I_k an, das die Vergleichsschwelle (Schwellenwert A) des Komparators 8 überschreitet, so wird am ersten Ausgangssignal S1 ein Impuls erzeugt. Im Falle eines vorliegenden sinusförmigen AC-Eingangssignals I_k (vgl. Figur 2) ist der Impuls des Ausgangssignals S1 zentriert um den Scheitelpunkt des Eingangssignals I_k, wobei dessen Breite von der tatsächlichen Amplitude des AC-Eingangssignals I_k abhängt, d.h. je höher die Amplitude, desto breiter der Impuls des ersten Ausgangssignals S1. Durch Auswerten des ersten Ausgangssignals S1 im Flip-Flop 14 zu einem Zeitpunkt T/8 bzw. 3T/8, getriggert durch das Taktsignal S3 des Zeitglieds Tv, 12, kann somit das AC-Eingangssignal I_k hinsichtlich seines Effektivwertes relativ zum Schwellenwert A ausgewertet werden. Dies wird unter Zuhilfenahme eines Grenzfalles, wie in Figur 2 veranschaulicht, nachfolgend näher erläutert.

Gemäß Figur 2 wird ein AC-Eingangssignal I_k unter Anwendung eines Schwellenwertes A von 6V erfasst. Während der ersten Periode (0..20ms bei 50Hz in diesem Beispiel) hat das Eingangssignal einen Effektivwert $U_{rms}$ von 6,5V, also eine Amplitude $U_{peak} = \sqrt{2} \times U_{rms}$ von 0,707 x 6,5V $\approx$ 9,2V, und liegt somit zum Zeitpunkt T/8 bzw. 3T/8 knapp über der Schwelle. Es muss als "1" gelesen werden, weil zum Zeitpunkt T/8 bzw. 3T/8 der Impuls des Ausgangssignals S1 bereits anliegt (an diesem Zeitpunkt wurde S1 bereits durch den Komparator 8 ausgelöst, weil der Schwellwert A schon überschritten ist).

Während der zweiten Periode (20..40ms) hat das AC-Eingangssignal einen Effektivwert $U_{rms}$ von 5,5V, also eine Amplitude $U_{peak} = \sqrt{2} \times U_{rms}$ von 0,707 x 5,5V ≈ 7,8V, und liegt somit zum Zeitpunkt T/8 bzw. 3T/8 knapp unter dem Schwellenwert A. Es muss als "0" gelesen werden, weil zum Zeitpunkt T/8 bzw. 3T/8 der Impuls des Ausgangssignals S1 (noch) nicht bzw. nicht mehr anliegt (an diesem Zeitpunkt wurde S1 noch nicht bzw. nicht mehr durch den Komparator 8 ausgelöst, weil der Schwellwert A noch nicht bzw. nicht mehr überschritten ist).

Wie man sieht, wird somit durch Auswertung des AC-Eingangssignals I_k bei T/8 oder 3T/8 der Effektivwert des AC-Eingangssignals berücksichtigt, der niedriger ist als der Spitzen- (Peak-) wert $U_{peak}$ (Amplitudenwert). Das AC-Eingangssignal I_k wird in der ersten Periode als "1" gelesen, während das AC-Eingangssignal I_k in der zweiten Periode als "0" gelesen wird. Obwohl das AC-Eingangssignal I_k in beiden Perioden mit seinem Spitzen-(Peak-) wert $U_{peak}$ (Amplitudenwert) den vorgegebenen Schwellenwert A überschreitet, kann das AC-Eingangssignal I_k bezüglich seines für den Schwellenwert A berücksichtigten Effektivwertes $U_{rms}$ korrekt ausgewertet werden.

Die erläuterte Funktionsweise der Schaltungsanordnung hat den Vorteil, dass für eine alternative Auswertung von DC-Eingangssignalen I_k (Gleichspannungssignale) und AC-Eingangssignalen I_k (sinusförmige Wechselspannungssignale) ein Schwellenwert A am Komparator 8 für die Überwachung eines normierten AC-Eingangssignals herangezogen werden kann, der für eine Überwachung eines DC-Eingangssignals ausgelegt ist, selbst wenn dieser Schwellenwert A niedriger ist als ein maximaler Spitzen-(Peak-)wert $U_{peak}$ eines AC-Eingangssignals I_k, wie in Figur 2 veranschaulicht. Durch Auswertung des AC-Eingangssignals I_k gezielt bei T/8 bzw. 3T/8 erfolgt eine Auswertung hinsichtlich des Effektivwertes $U_{rms}$ des AC-Eingangssignals I_k, der niedriger ist als dessen Spitzen-(Peak-)wert $U_{peak}$. Somit ermöglicht die Schaltungsanordnung sowohl eine Überwachung von sinusförmigen Wechselspannungssignalen (AC-Eingangssignalen) als auch eine Überwachung von Gleichspannungssignalen (DC-Eingangssignalen). Hierfür wird lediglich ein Komparator 8 benötigt, wobei lediglich ein einziger Schwellenwert A definiert werden muss. Dadurch wird ermöglicht, dass eine kombinierte Überwachung sowohl von AC- als auch von DC-Eingangssignalen I_k mit einem einfach und flexibel einzustellenden Komparator 8 durchgeführt werden kann. Die Schaltungsanordnung ist dennoch einfach zu implementieren.

Dem Komparator 8 können alternativ mehrere verschiedene zu überwachende AC- bzw. DC-Eingangssignale I_k oder jeweils daraus gewonnene Signale zuführbar sein. Der Komparator 8 erzeugt das erste Ausgangssignal S1 jeweils, wenn ein jeweiliges AC- bzw. DC-Eingangssignale I_k oder das daraus gewonnene Signal den definierten Schwellenwert A überschreitet. Der Schwellenwert A kann dabei unterhalb eines Spitzen-(Peak-)wertes eines normierten Low-Signals eines jeweiligen sinusförmigen AC-Eingangssignals I_k und oberhalb eines maximalen DC-Wertes eines normierten Low-Signals eines jeweiligen DC-Eingangssignals I_k festgelegt sein.

Beispielsweise erlaubt die erläuterte Schaltungsanordnung eine kombinierte Überwachung von 24V AC, 24V DC und 12V DC als jeweilige Eingangssignale I_k, wobei der Schwellenwert A z.B. bei ca. 6V, z.B. bei 6,4V festgelegt ist. Der Schwellenwert A liegt somit unterhalb eines maximalen Spitzen-(Peak-)wertes für ein Low-Signal (normiert bei 7,07V) des sinusförmigen 24V AC-Eingangssignals (und auch unterhalb eines minimalen Spitzen-(Peak-)wertes, normiert auf 19,8V, für ein High-Signal des sinusförmigen 24V AC-Eingangssignals) und oberhalb eines maximalen DC-Wertes für ein Low-Signal (normiert auf 5V) des 24V DC-Eingangssignals (und unterhalb eines minimalen DC-Wertes, normiert auf 15V, für ein High-Signal des 24V DC-Eingangssignals). Ein Schwellwert von 6V hat sich auch für die Überwachung einer unteren Schwelle (Low-Signal) eines überwachten 12V DC-Signals als ausreichend herausgestellt. Auf diese Weise können verschiedene Eingangssignale I_k, AC oder DC, überwacht und hinsichtlich ihrer normierten Schwellenwerte für Low- und High-Signale vermittels eines einzelnen Schwellenwertes A durch den Komparator 8 flexibel und einfach ausgewertet werden.

Fig. 1B zeigt eine alternative Ausführungsform der Schaltungsanordnung, die eine Weiterbildung der in Fig. 1A gezeigten Ausführungsform ist. Im Unterschied zu Fig. 1A wird in Fig. 1B ein anliegendes Eingangssignal I_k zuerst dem Tiefsetzer 6 zugeführt. Das Ausgangssignal des Tiefsetzers 6 wird durch eine erste und eine zweite Diode 4a, 4b gleichgerichtet. Die erste Diode 4a verbindet den Eingang des Komparators 8 mit einem Versorgungsspannungsanschluss. Am Versorgungsspannungsanschluss liegt eine Versorgungsspannung Vdd an. Die erste Diode 4a ist derart gepolt, dass eine Spannung am Eingang des Komparators 8 kleiner als die Versorgungsspannung Vdd (zuzüglich einer Schwellenspannung der ersten Diode 4a) ist. Die zweite Diode 4b verbindet den Eingang des Komparators 8 mit einem Massepotentialanschluss, an dem das Massepotential GND anliegt. Die zweite Diode 4b ist derart gepolt, dass die Spannung am Eingang des Komparators 8 größer als das Massepotential GND (abzüglich einer Schwellenspannung der zweiten Diode 4b) ist.

Der Komparator 8 kann als bipolarer Komparator realisiert sein. Der Komparator 8 erzeugt das erste Ausgangssignal S1 in Abhängigkeit von einem Vergleich der Spannung am Eingang des Komparators 8 und des Schwellenwerts A. Das erste Ausgangssignal S1 ist impulsförmig. Der Impuls des ersten Ausgangssignals S1 wird vom Mikrocontroller 16 zeitlich erfasst.

Alternativ kann der Komparator 8 als Inverter implementiert werden. Die Dioden 4a, 4b können z.B. im Inverter integriert sein. Die Dioden 4a, 4b können als Schutzdioden realisiert sein. Der Inverter weist einen "eingebauten" Schwellenwert A auf. Die erste und die zweite Diode 4a, 4b können optional zusammen mit dem Inverter auf einem Halbleiterkörper integriert sein (z.B. ein CMOS-Inverter vom Typ HC04).

Zur Erzeugung des zweiten Ausgangssignals S2 vermittels des Nulldurchgangsdetektors 10 wird im Ausführungsbeispiel gemäß Fig. 1B ein anliegendes Eingangssignal I_k zuerst dem Widerstand R3, 5 zugeführt und dann durch eine erste und eine zweite Diode 3a, 3b gleichgerichtet. Die erste Diode 3a verbindet den Eingang des Nulldurchgangsdetektors 10 mit dem Versorgungsspannungsanschluss. Die erste Diode 3a ist derart gepolt, dass eine Spannung am Eingang des Nulldurchgangsdetektors 10 kleiner als die Versorgungsspannung Vdd (zuzüglich einer Schwellenspannung der ersten Diode 3a) ist. Die zweite Diode 3b verbindet den Eingang des Nulldurchgangsdetektors 10 mit dem Massepotentialanschluss. Die zweite Diode 3b ist derart gepolt, dass die Spannung am Eingang des Nulldurchgangsdetektors 10 größer als das Massepotential GND (abzüglich einer Schwellenspannung der zweiten Diode 3b) ist. Das zweite Ausgangssignal S2 ist impulsförmig.

Der Nulldurchgangsdetektors 10 kann als bipolarer Komparator realisiert sein.

Alternativ kann der Nulldurchgangsdetektors 10 als Inverter implementiert sein. Die Dioden 3a, 3b können z.B. im Inverter integriert sein. Die Dioden 3a, 3b können als Schutzdioden realisiert sein. Der Nulldurchgangsdetektor 10 weist einen "eingebauten" Schwellenwert auf. Da die dem Nulldurchgangsdetektor 10 zugeführte Spannung nicht heruntergeteilt ist, ist der Spannungsanstieg schnell. So ist der zeitliche Versatz zwischen dem Nulldurchgang der zugeführten Spannung und dem Schalten des Nulldurchgangsdetektors 10 sehr gering und kann vernachlässigt werden.

Der Schwellenwert des Nulldurchgangsdetektors 10 kann 0 V (also das Massepotential, wie in Fig. 1B) oder eine von 0 V verschiedene Spannung sein, z.B. eine kleine positive Spannung (z.B. 2 V).

In alternativen, nicht gezeigten Ausführungsformen, kann der Komparator 8 und/oder der Nulldurchgangsdetektor 10 als ein CMOS-Gatter, z.B. ein CMOS-Gatter vom Typ HC, oder als ein Transistor realisiert werden. Bei dem Transistor kann der Schwellenwert A z.B. diejenige Basis-Emitter Spannung sein, ab der ein Strom durch den Transistor fließt (z.B. Ube = ca. 0,65 V). Die Widerstandwerte der Widerstände R1, R2 des Tiefsetzers 6 sind dann entsprechend dimensioniert. Es können dann ausschließlich die zweiten Dioden 4b bzw. 3b vorgesehen sein. Die ersten Dioden 4a bzw. 3a können weggelassen werden.

Der Komparator 8 kann als ein Baustein, dem die Dioden 4a, 4b als Schutzdioden extern vorgeschaltet sind, oder als ein Baustein mit integrierten Dioden 4a, 4b (wie z.B. ein CMOS-Inverter mit Schutzdioden etwa HC04) hergestellt sein.

Der Nulldurchgangsdetektor 10 kann als ein Baustein, dem die Dioden 3a, 3b als Schutzdioden extern vorgeschaltet sind, oder als ein Baustein mit integrierten Dioden 3a, 3b (wie z.B. ein CMOS-Inverter mit Schutzdioden etwa HC04) hergestellt sein. Die Schutzdioden können Schutzdioden gegen elektrostatische Aufladung, abgekürzt ESD-Schutzdioden, sein.

Die Vorverarbeitung (Gleichrichten, Tiefsetzen) ist in Figuren 1A und 1B ausschließlich beispielhaft dargestellt und kann auch mit alternativen Schaltungen realisiert sein. Das Gleichrichten kann gegebenenfalls entfallen. Die Vorverarbeitung ist ausgelegt, den Komparator 8 und/oder den Nulldurchgangsdetektor 10 gegen Überspannungen (Eingang > positive Versorgung + Toleranz) und Unterspannungen (Eingang < negative Versorgung, ggf. Massepotential GND - Toleranz) zu schützen. Diese Funktion kann optional auch eine Gleichrichterdiode 3b, 4b für (negative) Unterspannungen übernehmen, ggf. kann ein zusätzlicher Schutz gegen Überspannung vorgesehen sein.

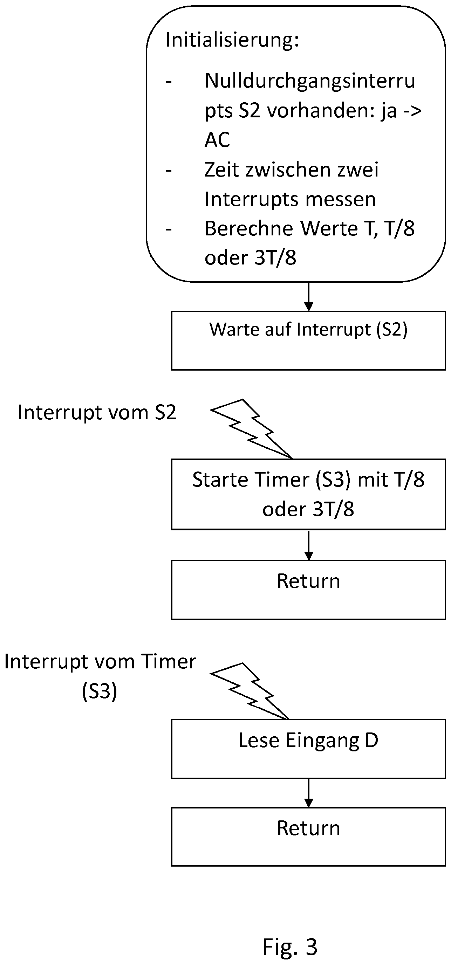

Fig. 3 zeigt prinzipiell, wie die Verarbeitung der erläuterten Signale und Bereitstellung der entsprechenden Funktionalitäten in Software (innerhalb des Mikrocontrollers 16) erfolgen kann. Im Folgenden wird von einem zu überwachenden AC-Eingangssignal I_k ausgegangen. In einer Interrupt-Routine des Mikrocontrollers 16 wird, ausgelöst durch einen Interrupt des zweiten Ausgangssignals S2 (Nulldurchgangssignal), ein Timer (Signal S3) zur Realisierung des Zeitglieds 12 mit dem Wert T/8 bzw. 3T/8 gestartet, der am Ende (nach dessen Ablauf) einen weiteren Interrupt erzeugt. Zu diesem Zeitpunkt wird das erste Ausgangsignal S1 (des Komparators 8) am Eingang D des Flip-Flops 14 gelesen und entsprechend das Zustandssignal S4 im Speicher abgelegt. Ein Timer kann auch Zeitgeber genannt werden. Der Interrupt kann auch als Unterbrechung bezeichnet werden.

Um die Periode T zu ermitteln, wird beim Einschalten und Initialisieren des Mikrocontrollers 16 bzw. des Gerätes das Nulldurchgangssignal S2 zeitlich gemessen (vergleiche Fig. 3 oben). Man misst über einen Timer die Zeitabstände zwischen zwei aufeinander folgenden Impulsen. In der Regel unterscheidet man dadurch zwischen 50Hz und 60Hz, aber andere Frequenzen können auch unterstützt werden. Anschließend werden die Timer-Werte T/8 bzw. 3T/8 berechnet.

Die dargestellten Ausführungsformen sind lediglich beispielhaft. In alternativen, nicht-dargestellten Ausführungsformen, die in den Figuren 1A und 1B mittels Punkten angedeutet sind, kann neben den erläuterten Eingangssignalen I_k mindestens ein weiteres Eingangssignal I_k' der Schaltungsanordnung zugeführt werden. Die Schaltungsanordnung kann mindestens einen weiteren Komparator und ein nachgeschaltetes weiteres Flip-Flop umfassen. Die Signale des Nulldurchgangsdetektors 10 und des Zeitglieds 12 sind geeignet zu überwachen, ob das weitere Eingangssignal I_k' den Schwellenwert A über- oder unterschreitet. Allgemein kann eine Anzahl von n Eingangssignalen I_k der Schaltungsanordnung zugeleitet und erfasst werden. Dabei kann n gleich 1 oder 2 oder größer als 2 sein. Wie erläutert können die Eingangssignale I_k AC-Eingangssignale und/oder DC-Eingangssignale sein. Alternativ zu den erläuterten Eingangssignalen von 24V AC, 24V DC bzw. 12V DC können natürlich auch andere Signalwerte mit deren (normierten oder sonst festgelegten) Schwellen, z.B. für Low- oder High-Signale, herangezogen werden.

Bezugszeichenliste:

| | |
|---|---|
| 3, 3a, 3b | Diode |
| 4, 4a, 4b | Diode |
| 5 | Widerstand |
| 6 | Tiefsetzer |
| 8 | Komparator |
| 10 | Nulldurchgangsdetektor |
| 12 | Zeitglied |
| 14 | Flip-Flop |
| 16 | Mikrocontroller |
| 17 | Schalter |
| 18 | Umschalter |
| A | Schwellenwert |
| D | Dateneingang des Flip-Flops |
| Clk | Takteingang des Flip-Flops |
| I_k | Eingangssignal |
| GND | Massepotential |
| L | Phase |
| N | Neutralleiter |
| S1 | erstes Ausgangssignal |
| S2 | zweites Ausgangssignal |
| S3 | Taktsignal |
| S4 | Zustandssignal |
| S5 | Ausgangssignal |
| $U_{rms}$ | Effektivwert |
| $U_{peak}$ | Spitzen- (Peak-) wert |
| U | Spannung |
| +Us | DC-Versorgungsspannung |
| 0V | DC-Bezugspotential |
| Vdd | Versorgungsspannung |
| T | Periodendauer |

**Patentansprüche**

1. Schaltungsanordnung zur Überwachung eines sinusförmigen Wechselspannungssignals (I_k) mit:

- einem Vergleicher (8), dem an einem Eingang ein zu überwachendes, sinusförmiges Wechselspannungssignal (I_k) mit einer Periodendauer T oder ein daraus gewonnenes Signal zuführbar ist, wobei der Vergleicher (8) eingerichtet ist an einem Ausgang ein erstes Ausgangssignal (S1) zu erzeugen, wenn das sinusförmige Wechselspannungssignal (I_k) oder das daraus gewonnene Signal einen definierten Schwellenwert (A) überschreitet,
- einem Nulldurchgangsdetektor (10), dem an einem Überwachungseingang das zu überwachende, sinusförmige Wechselspannungssignal (I_k) oder ein daraus gewonnenes Signal zuführbar ist, sodass an einem Ausgang des Nulldurchgangsdetektors (10) ein zweites Ausgangssignal (S2) erzeugbar ist,
- einem dem Nulldurchgangsdetektor (10) nachgeschalteten Zeitglied (12) zur Erzeugung eines Taktsignals (S3) in Abhängigkeit vom zweiten Ausgangssignal (S2),
- einem flankengesteuerten Flip-Flop (14),
wobei der Ausgang des Vergleichers (8) mit einem zustandsgesteuerten Eingang (D) des Flip-Flops (14) verbunden ist und wobei ein Ausgang des Zeitglieds (12) mit einem flankengesteuerten Eingang (Clk) des Flip-Flops (14) verbunden ist derart, dass ein Zustandssignal (S4) an einem Ausgang des Flip-Flops (14) erzeugbar ist,

**dadurch gekennzeichnet, dass**

das Zeitglied (12) eingerichtet ist, einen definierten Zustandswechsel des Taktsignals (S3) zu einem Zeitpunkt bei T/8 bzw. 3T/8 der Periodendauer T nach einem Nulldurchgang des sinusförmigen Wechselspannungssignals (I_k) vorzugeben.

2. Schaltungsanordnung nach Anspruch 1, wobei der Vergleicher (8) ein Komparator ist und der Eingang ein erster Vergleichseingang des Komparators ist zum Vergleich des zu überwachenden, sinusförmigen Wechselspannungssignals (I_k) oder des daraus gewonnenen Signals mit dem an einem zweiten Vergleichseingang des Komparators anliegenden, definierten Schwellenwert (A).

3. Schaltungsanordnung nach einem der Ansprüche 1 bis 2, wobei dem Vergleicher (8) an seinem Eingang alternativ ein zu überwachendes Gleichspannungssignal (I_k) oder ein daraus gewonnenes Signal zuführbar ist, wobei der Vergleicher (8) eingerichtet ist an seinem Ausgang das erste Ausgangssignal (S1) zu erzeugen, wenn das Gleichspannungssignal (I_k) oder das daraus gewonnene Signal den definierten Schwellenwert (A) überschreitet.

4. Schaltungsanordnung nach einem der Ansprüche 1 bis 3, ferner aufweisend einen Umschalter (18) zum Umschalten eines Signalausgangs (S5) der Schaltungsanordnung zwischen dem Ausgang des Flip-Flops (14) und dem Ausgang des Vergleichers (8), wobei der Umschalter (18) vermittels eines Steuersignals steuerbar ist.

5. Verfahren zur Überwachung eines sinusförmigen Wechselspannungssignals (I_k) mit folgenden Verfahrensschritten:

   - Erfassen eines zu überwachenden, sinusförmigen Wechselspannungssignals (I_k) mit einer Periodendauer T,
   - Prüfen, ob das erfasste sinusförmige Wechselspannungssignal (I_k) oder ein daraus gewonnenes Signal einen definierten Schwellenwert (A) überschreitet, und in Abhängigkeit davon Erzeugen eines ersten Ausgangssignals (S1),
   - Überwachen der Nulldurchgänge des sinusförmigen Wechselspannungssignals (I_k) oder eines daraus gewonnenen Signals und in Abhängigkeit davon Erzeugen eines zweiten Ausgangssignals (S2),
   - Erzeugen eines Taktsignals (S3) in Abhängigkeit vom zweiten Ausgangssignal (S2) und
   - Erzeugen eines Zustandssignals (S4) durch Auswerten des ersten Ausgangssignals (S1) im Zeitpunkt eines definierten Zustandswechsels des Taktsignals (S3),

   **dadurch gekennzeichnet, dass**

   der definierte Zustandswechsel des Taktsignals (S3) zu einem Zeitpunkt bei T/8 bzw. 3T/8 der Periodendauer T nach einem Nulldurchgang des sinusförmigen Wechselspannungssignals (I_k) vorgegeben wird.

6. Verfahren nach Anspruch 5, wobei das Taktsignal (S3) durch ein Zeitglied (12) erzeugt wird, das durch das zweite Ausgangssignal (S2) zur Erzeugung des Taktsignals (S3) getriggert wird.

7. Verfahren nach Anspruch 5 oder 6, wobei das Zeitglied (12) softwaregesteuert innerhalb eines Mikrocontrollers (16) realisiert ist und die folgenden Verfahrensschritte durchgeführt werden:

   - Erzeugen eines ersten Interrupts im Mikrocontroller (16) durch das zweite Ausgangssignal (S2),
   - Starten eines Timers des Mikrocontrollers (16) zur Realisierung des Zeitglieds (12a) bei Auftreten des ersten Interrupts,
   - Erzeugen eines zweiten Interrupts im Mikrocontroller (16) bei Ablauf des Timers, sowie
   - Lesen des bei Auftreten des zweiten Interrupts vorliegenden Wertes des ersten Ausgangssignals (S1) als Zustandssignal (S4).

8. Verfahren nach einem der Ansprüche 5 bis 7, wobei die folgenden weiteren Verfahrensschritte durchgeführt werden:

   - Erfassen eines zu überwachenden Gleichspannungssignals (I_k) alternativ zum sinusförmigen Wechselspannungssignal (I_k),
   - Prüfen, ob das erfasste Gleichspannungssignal (I_k) oder ein daraus gewonnenes Signal den definierten Schwellenwert (A) überschreitet, und in Abhängigkeit davon Erzeugen des ersten Ausgangssignals (S1).

**9.** Software-Produkt, das eingerichtet ist, innerhalb eines Mikrocontrollers (16) ausgeführt zu werden, und das bei dessen Ausführung ein Verfahren nach einem der Ansprüche 5 bis 8 durchführt.

**Claims**

**1.** Circuit assembly for monitoring a sinusoidal alternating voltage signal (I_k), the circuit assembly comprising:

- a comparator (8) to which a sinusoidal alternating voltage signal (I_k) to be monitored having a period T or a signal obtained therefrom can be supplied at an input, the comparator (8) being configured to generate a first output signal (S1) at an output if the sinusoidal alternating voltage signal (I_k) or the signal obtained therefrom exceeds a defined threshold value (A),
- a zero crossing detector (10) to which the sinusoidal alternating voltage signal (I_k) to be monitored or a signal obtained therefrom can be supplied at a monitoring input such that a second output signal (S2) can be generated at an output of the zero crossing detector (10),
- a timing element (12) which is connected downstream of the zero crossing detector (10) and is intended for generating a clock signal (S3) depending on the second output signal (S2),
- an edge-controlled flip-flop (14),
the output of the comparator (8) being connected to a state-controlled input (D) of the flip-flop (14) and an output of the timing element (12) being connected to an edge-controlled input (Clk) of the flip-flop (14) such that a state signal (S4) can be generated at an output of the flip-flop (14), **characterized in that**
the timing element (12) is configured to specify a defined state change of the clock signal (S3) at a time at T/8 or 3T/8 of the period T after a zero crossing of the sinusoidal alternating voltage signal (I_k).

**2.** Circuit assembly according to claim 1, wherein the comparator (8) is a comparator and the input is a first comparison input of the comparator for comparing the sinusoidal alternating voltage signal (I_k) to be monitored or the signal obtained therefrom with the defined threshold value (A) applied to a second comparison input of the comparator.

**3.** Circuit assembly according to either of claims 1 and 2, wherein the comparator (8) can alternatively be supplied at its input with a direct voltage signal (I_k) to be monitored or a signal obtained therefrom, wherein the comparator (8) is configured to generate the first output signal (S1) at the output thereof if the direct voltage signal (I_k) or the signal obtained therefrom exceeds the defined threshold value (A) .

**4.** Circuit assembly according to any of claims 1 to 3, further having a change-over switch (18) for switching a signal output (S5) of the circuit assembly between the output of the flip-flop (14) and the output of the comparator (8), wherein the change-over switch (18) is controllable by means of a control signal.

**5.** Method for monitoring a sinusoidal alternating voltage signal (I_k), the method comprising the following method steps:

- detecting a sinusoidal alternating voltage signal (I_k) to be monitored having a period T,
- checking whether the detected sinusoidal alternating voltage signal (I_k) or a signal obtained therefrom exceeds a defined threshold value (A) and, depending thereon, generating a first output signal (S1),
- monitoring the zero crossings of the sinusoidal alternating voltage signal (I_k) or a signal obtained therefrom and, depending thereon, generating a second output signal (S2),
- generating a clock signal (S3) depending on the second output signal (S2) and
- generating a state signal (S4) by evaluating the first output signal (S1) at the time of a defined state change of the clock signal (S3), **characterized in that**

the defined state change of the clock signal (S3) at a time at T/8 or 3T/8 of the period T is specified after a zero crossing of the sinusoidal alternating voltage signal (I_k).

**6.** Method according to claim 5, wherein the clock signal (S3) is generated by a timing element (12) which is triggered by the second output signal (S2) to generate the clock signal (S3) .

**7.** Method according to claim 5 or 6, wherein the timing element (12) is software controlled within a microcontroller (16) and the following method steps are carried out:

- generating a first interrupt in the microcontroller (16) via the second output signal (S2),

- starting a timer of the microcontroller (16) to implement the timing element (12a) when the first interrupt occurs,
- generating a second interrupt in the microcontroller (16) when the timer expires, and
- reading the value of the first output signal (S1) that is present when the second interrupt occurs as a state signal (S4) .

8. Method according to any of claims 5 to 7, wherein the following further method steps are carried out:

- detecting, alternatively to the sinusoidal alternating voltage signal (I_k), a direct voltage signal (I_k) to be monitored,
- checking whether the detected direct voltage signal (I_k) or a signal obtained therefrom exceeds the defined threshold value (A) and, depending thereon, generating the first output signal (S1).

9. Software product which is configured to be executed within a microcontroller (16) and which, when executed, carries out a method according to any of claims 5 to 8.

**Revendications**

1. Agencement de circuit permettant de surveiller un signal (I_k) sinusoïdal de tension alternative, comportant :

- un dispositif de comparaison (8) auquel peut être amené, au niveau d'une entrée, un signal (I_k) sinusoïdal de tension alternative à surveiller ayant une durée de période T ou un signal obtenu à partir de celui-ci, dans lequel le dispositif de comparaison (8) est conçu pour générer un premier signal de sortie (S1) au niveau d'une sortie lorsque le signal (I_k) sinusoïdal de tension alternative ou le signal obtenu à partir de celui-ci dépasse une valeur seuil (A) définie,
- un détecteur de passage par zéro (10), auquel peut être amené, au niveau d'une entrée de surveillance, le signal (I_k) sinusoïdal de tension alternative à surveiller ou un signal obtenu à partir de celui-ci, de sorte qu'un second signal de sortie (S2) puisse être généré au niveau d'une sortie du détecteur de passage par zéro (10),
- un temporisateur (12) monté en aval du détecteur de passage par zéro (10) pour générer un signal d'horloge (S3) en fonction du second signal de sortie (S2),
- une bascule commandée par front (14),
dans lequel la sortie du dispositif de comparaison (8) est connectée à une entrée (D), commandée en fonction de l'état, de la bascule (14) et dans lequel une sortie du temporisateur (12) est connectée à une entrée (Clk) commandée par front de la bascule (14) de sorte qu'un signal d'état (S4) puisse être généré au niveau d'une sortie de la bascule (14), **caractérisé en ce que**
le temporisateur (12) est conçu pour définir, à un moment, un changement d'état défini du signal d'horloge (S3) à T/8 ou 3T/8 de la durée de période T après un passage par zéro du signal (I_k) sinusoïdal de tension alternative.

2. Agencement de circuit selon la revendication 1, dans lequel le dispositif de comparaison (8) est un comparateur et l'entrée est une première entrée de comparaison du comparateur, permettant de comparer le signal (I_k) sinusoïdal de tension alternative à surveiller ou le signal obtenu à partir de celui-ci à la valeur seuil (A) définie appliquée au niveau d'une seconde entrée de comparaison du comparateur.

3. Agencement de circuit selon l'une des revendications 1 à 2, dans lequel de manière alternative, un signal (I_k) de tension continue à surveiller ou un signal obtenu à partir de celui-ci peut être amené au dispositif de comparaison (8), au niveau de son entrée, dans lequel le dispositif de comparaison (8) est conçu pour générer, au niveau de sa sortie, le premier signal de sortie (S1) lorsque le signal (I_k) de tension continue ou le signal obtenu à partir de celui-ci dépasse la valeur seuil (A) définie.

4. Agencement de circuit selon l'une des revendications 1 à 3, présentant en outre un commutateur (18) permettant de commuter une sortie de signal (S5) de l'agencement de circuit entre la sortie de la bascule (14) et la sortie du dispositif de comparaison (8), dans lequel le commutateur (18) peut être commandé au moyen d'un signal de commande.

5. Procédé permettant de surveiller un signal (I_k) sinusoïdal de tension alternative, comprenant les étapes de procédé suivantes :

- détection d'un signal (I_k) sinusoïdal de tension alternative à surveiller ayant une durée de période T,

- vérification établissant si le signal (I_k) sinusoïdal de tension alternative détecté ou un signal obtenu à partir de celui-ci dépasse une valeur seuil (A) définie et, en fonction du résultat, génération d'un premier signal de sortie (S1),
- surveillance des passages par zéro du signal (I_k) sinusoïdal de tension alternative ou d'un signal obtenu à partir de celui-ci et, en fonction du résultat, génération d'un second signal de sortie (S2),
- génération d'un signal d'horloge (S3) en fonction du second signal de sortie (S2) et
- génération d'un signal d'état (S4) par évaluation du premier signal de sortie (S1) au moment d'un changement d'état défini du signal d'horloge (S3), **caractérisé en ce que**

le changement d'état défini du signal d'horloge (S3) à un moment est défini à T/8 ou 3T/8 de la durée de période T après un passage par zéro du signal (I_k) sinusoïdal de tension alternative.

6. Procédé selon la revendication 5, dans lequel le signal d'horloge (S3) est généré par un temporisateur (12) qui est déclenché par le second signal de sortie (S2) pour générer le signal d'horloge (S3).

7. Procédé selon la revendication 5 ou 6, dans lequel le temporisateur (12) est réalisé de manière commandée par logiciel dans un micro-contrôleur (16) et les étapes de procédé suivantes sont exécutées :

- génération d'une première interruption dans le micro-contrôleur (16) par le second signal de sortie (S2),
- démarrage d'un minuteur du micro-contrôleur (16) pour réaliser le temporisateur (12a) lors de l'apparition de la première interruption,
- génération d'une seconde interruption dans le micro-contrôleur (16) à l'expiration du minuteur, ainsi que
- lecture de la valeur du premier signal de sortie (S1) présente lors de l'apparition de la seconde interruption en tant que signal d'état (S4).

8. Procédé selon l'une des revendications 5 à 7, dans lequel les étapes de procédé supplémentaires suivantes sont exécutées :

- détection d'un signal (I_k) de tension continue à surveiller comme alternative au signal (I_k) sinusoïdal de tension alternative,
- vérification établissant si le signal (I_k) de tension continue détecté ou un signal obtenu à partir de celui-ci dépasse la valeur seuil (A) définie et, en fonction du résultat, génération du premier signal de sortie (S1).

9. Produit logiciel, qui est conçu pour être exécuté dans un micro-contrôleur (16) et qui, lors de son exécution, met en œuvre un procédé selon l'une des revendications 5 à 8.

Fig. 1A

Fig. 1B

Fig. 2

Initialisierung:

- Nulldurchgangsinterru
  pts S2 vorhanden: ja ->
  AC
- Zeit zwischen zwei
  Interrupts messen
- Berechne Werte T, T/8
  oder 3T/8

Warte auf Interrupt (S2)

Interrupt vom S2

Starte Timer (S3) mit T/8
oder 3T/8

Return

Interrupt vom Timer
(S3)

Lese Eingang D

Return

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0935758 A
- DE 19748632 A1